# EUROPÄISCHE PATENTSCHRIFT

(11) **EP 2 378 578 B1**
(45) Veröffentlichungstag und Bekanntmachung des Hinweises auf die Patenterteilung: **21.10.2015**
(21) Anmeldenummer: 11156726.9
(22) Anmeldetag: 03.03.2011
(51) Int. Cl.: H01L 35/30, F28D 7/00, F01N 5/02, F28D 21/00, F28F 13/00

(54) **Wärmeübertrager und Herstellungsverfahren**
Heat exchanger and method of making it
Echangeur de chaleur et procédé de fabrication

(30) Priorität: 17.04.2010 DE 102010015321
(43) Veröffentlichungstag der Anmeldung: 19.10.2011
(73) Patentinhaber: Eberspächer Exhaust Technology GmbH & Co. KG, 66539 Neunkirchen (DE)
(72) Erfinder: Spieth, Arnulf, 73269, Hochdorf (DE); Bürkle, Anika, 70199, Stuttgart (DE); Dong, Ming, 7034, Stuttgart (DE); Oesterle, Jörg, 89150, Laichingen (DE); Sachse, Angela, 70771, Leinfelden-Echterdingen (DE)
(74) Vertreter: BRP Renaud & Partner mbB Rechtsanwälte Patentanwälte Steuerberater

(56) Entgegenhaltungen:
- EP-A1- 1 522 685
- DE-A1-102007 035 931
- DE-T2- 60 207 230
- GB-A- 2 336 943
- JP-A- 2003 110 156
- JP-A- 2009 295 752
- US-A- 4 730 459
- US-A1- 2004 177 623
- US-A1- 2006 157 102
- US-A1- 2008 142 067

## Beschreibung

Die vorliegende Erfindung betrifft einen Wärmeübertrager, insbesondere für eine Abgasanlage einer Brennkraftmaschine, vorzugsweise eines Kraftfahrzeugs. Die Erfindung betrifft außerdem ein Verfahren zum Zusammenbauen eines derartigen Wärmeübertragers.

Ein Wärmeübertrager weist üblicherweise zumindest ein Warmrohr zum Führen eines Wärme enthaltenden oder abgebenden Fluids sowie wenigstens ein Kaltrohr zum Führen eines Wärme aufnehmenden Fluids auf. Diese Rohre sind wärmeübertragend miteinander gekoppelt, so dass Wärme aus dem Fluid des Warmrohrs in das Fluid des Kaltrohrs übertragen werden kann.

Grundsätzlich ist es dabei möglich, zumindest einen thermoelektrischen Generator zwischen Warmrohr und Kaltrohr anzuordnen, mit dessen Hilfe elektrische Energie aus einem Wärmestrom bzw. aus einer Temperaturdifferenz erzeugt werden kann. Ein derartiger thermoelektrischer Generator entspricht dabei einem Peltier-Element. Beim Peltier-Element oder beim thermoelektrischen Generator, der auch als TEG bezeichnet werden kann, wird durch Ausnutzung des Peltier-Effekts aus einer Spannungsdifferenz ein Wärmestrom erzeugt. Die Umkehrung dieses Peltier-Effekts ist der Seebeck-Effekt, der aus einer Temperaturdifferenz einen elektrischen Strom erzeugt. Hierzu kommen bei einem TEG bzw. Peltier-Element Halbleiter auf unterschiedlichem Energieniveau zum Einsatz.

Da im Abgas einer Brennkraftmaschine üblicherweise viel Abwärme anfällt, ist es durch den Einsatz eines derartigen Wärmeübertragers mit zumindest einem integrierten TEG möglich, Energie in Form von Wärme und elektrischem Strom zurückzugewinnen. Diese Energie kann dann an anderer Stelle der Brennkraftmaschine oder eines damit ausgestatteten Kraftfahrzeugs genutzt werden, um den Gesamtwirkungsgrad des jeweiligen Systems zu verbessern.

EP 1 522 685 A1 (TOYOTA MOTOR CO LTD [JP]) 13. April 2005 (2005-04-13) offenbart einen Wärmeübertrager, insbesondere für eine Abgasanlage einer Brennkraftmaschine, vorzugsweise eines Kraftfahrzeugs, mit wenigstens einem thermoelektrischen Generator zum Erzeugen von elektrischer Energie aus einer Temperaturdifferenz. Je ein thermoelektrischer Generator ist zwischen einem Warmrohr und einem Kaltrohr angeordnet, wobei der jeweilige thermoelektrische Generator über ein Wärmeleitmaterial mit dem jeweiligen Rohr in Kontakt steht. Das jeweilige Wärmeleitmaterial ist als Formkörper ausgestaltet.

Die vorliegende Erfindung beschäftigt sich mit dem Problem, für einen derartigen Wärmeübertrager bzw. für ein zugehöriges Herstellungsverfahren eine verbesserte oder zumindest eine andere Ausführungsform anzugeben, die sich insbesondere durch einen verbesserten Wirkungsgrad des Wärmeübertragers bzw. durch eine vereinfachte Herstellung des Wärmeübertragers auszeichnet.

Dieses Problem wird erfindungsgemäß durch die Gegenstände der unabhängigen Ansprüche gelöst. Vorteilhafte Ausführungsformen sind Gegenstand der abhängigen Ansprüche.

Die Erfindung beruht auf dem allgemeinen Gedanken, zwischen dem jeweiligen TEG und dem jeweiligen Rohr ein Wärmeleitmaterial anzuordnen, das die Wärmeübertragung zwischen dem jeweiligen TEG und dem jeweiligen Rohr verbessert. Eine verbesserte Wärmeübertragung erhöht den Wärmestrom und letztlich die Temperaturdifferenz zwischen Warmseite und Kaltseite des jeweiligen TEGs. Da der mit Hilfe des jeweiligen TEGs erzeugbare elektrische Strom von der Temperaturdifferenz abhängt, führt eine erhöhte Temperaturdifferenz zu einer erhöhten Stromproduktion.

Von besonderem Vorteil ist eine spezielle Ausführungsform, bei welcher das jeweilige Wärmeleitmaterial als Formkörper ausgestaltet ist. Die Verwendung eines derartigen aus Wärmeleitmaterial hergestellten Formkörpers ermöglicht zum einen eine verbesserte geometrische Anpassung des Wärmeleitmaterials einerseits an das jeweilige Rohr und andererseits an den jeweiligen TEG. Eine verbesserte geometrische Anpassung führt zu einem großflächigen, insbesondere lückenlosen, Kontakt, was die Wärmeübertragung verbessert. Zum anderen kann der Formkörper aufgrund seiner Formgebung zur Positionierung des jeweiligen TEGs relativ zum jeweiligen Rohr - und umgekehrt - genutzt werden, was insbesondere bei der Herstellung, also beim Zusammenbau des Wärmeübertragers von Vorteil ist. Beispielsweise lassen sich dadurch mehrere Kaltrohre, Warmrohre und thermoelektrische Generatoren mit Hilfe dieser Formkörper einfacher aufeinander stapeln, was die Handhabung der einzelnen Komponenten während des Fertigungsprozesses vereinfacht.

Darüber hinaus hat sich gezeigt, dass es durch die Verwendung derartiger Formkörper möglich ist, einen in der Stapelrichtung der einzelnen Komponenten orientierten Anpressdruck vergleichsweise hoch zu wählen. Einerseits führt eine geometrische Adaption der Formkörper an die jeweiligen Rohre und an den jeweiligen TEG zu einer gleichmäßigen Flächenpressung, was die Belastung der einzelnen Komponenten homogenisiert und somit reduziert. Andererseits gewährleistet die mit Hilfe der Formkörper verbesserte Lagefixierung bzw. Positionierung der einzelnen Komponenten zueinander auch bei erhöhten Anpressdrücken einen stabilen Verband, der insbesondere -je nach Ausgestaltung - mit zunehmendem Anpressdruck sogar stabiler werden kann.

Von besonderem Vorteil ist eine Ausführungsform, bei welcher der jeweilige TEG mit Hilfe des jeweiligen Formkörpers am jeweiligen Rohr in Position gehalten ist. Diese Bauweise verbessert somit die Fixierungswirkung bzw. Haltewirkung des jeweiligen Formkörpers. Dies kann beispielsweise durch eine entsprechende, komplementäre Formgebung des jeweiligen Formkörpers einerseits zum jeweiligen TEG und andererseits zum jeweiligen Rohr realisiert werden.

Gemäß einer anderen vorteilhaften Ausführungsform kann am jeweiligen Formkörper zumindest eine Erhebung oder Vertiefung ausgebildet sein, die mit einer dazu komplementären Vertiefung bzw. Erhebung zusammenwirkt, die am jeweiligen TEG oder am jeweiligen Rohr ausgebildet ist. Eine derartige Erhebung kann beispielsweise linienförmig in Form einer Sicke oder punktförmig in Form einer Warze ausgebildet sein. Die dazu komplementäre Vertiefung ist dann als dazu passende Gegensicke oder Gegenwarze ausgeformt. Dabei ist klar, dass eine beliebige Anzahl an Sicken und Warzen miteinander kombiniert sein kann. Ebenso können unterschiedlich dimensionierte Sicken bzw. Warzen vorhanden sein. Durch die Verwendung derartiger zusammenwirkender, insbesondere in Eingriff stehender, Erhebungen und Vertiefungen lässt sich eine formschlüssige Positionierung zwischen dem jeweiligen Formkörper und dem jeweiligen TEG bzw. dem jeweiligen Rohr realisieren. Dabei wirkt die formschlüssige Positionierung quer zu einer Stapelrichtung, der aufeinander liegenden Komponenten.

Die jeweilige Erhebung oder Vertiefung oder eine aus mehreren Erhebungen oder Vertiefungen bestehende Erhebungsanordnung oder Vertiefungsanordnung kann den jeweiligen TEG oder zumindest ein thermoelektrisches Generatorelement eines aus mehreren TEG-Elementen gebildeten TEGs seitlich umfassen. Hierdurch wird eine formschlüssige Positionierung des TEGs quer zur Stapelrichtung in allen Richtungen realisiert.

Entsprechend der Erfindung weist der jeweilige Formkörper einen Rand auf, der den jeweiligen TEG oder zumindest ein TEG-Element zumindest teilweise seitlich einfasst. Auch mit Hilfe eines derartigen Rands kann quer zur Stapelrichtung eine effektive formschlüssige Positionierung des jeweiligen Formkörpers am jeweiligen TEG bzw. am jeweiligen Rohr realisiert werden.

Bei einer anderen Ausführungsform kann als weiteres Bauteil zumindest ein Rahmen vorgesehen sein, der den jeweiligen TEG seitlich einfasst. Insbesondere für den Fall, dass der TEG aus mehreren TEG-Elementen besteht, die nebeneinander angeordnet sind, vereinfacht ein derartiger Rahmen die Positionierung und Handhabung des TEGs während der Montage und im fertigen Wärmeübertrager.

Gemäß einer vorteilhaften Weiterbildung kann der jeweilige Formkörper am jeweiligen Rahmen abgestützt sein, wodurch sich eine zusätzliche Stabilisierung innerhalb der Struktur des Wärmeübertragers ergibt.

Besonders zweckmäßig ist es, in den jeweiligen Formkörper elektrische Leitungen zum elektrischen Kontaktieren des jeweiligen TEGs oder der jeweiligen TEG-Elemente zu integrieren. Hierdurch erhält der jeweilige Formkörper eine Zusatzfunktion, welche die elektrische Kontaktierung des jeweiligen TEGs innerhalb des Wärmeübertragers vereinfacht. Insbesondere kann auf die Verlegung zusätzlicher elektrischer Leitungen innerhalb des Wärmeübertragers verzichtet werden.

Der jeweilige Formkörper kann formstabil und/oder elastisch ausgestaltet sein. Er kann mit dem jeweiligen Rohr bzw. mit dem jeweiligen TEG verklebt sein. Das Wärmeleitmaterial, aus welchem der Formkörper gebildet ist, kann elektrisch isolierend ausgestaltet sein. Es kann faserverstärkt sein. Ferner kann das Wärmeleitmaterial als Basismaterial Graphit aufweisen, sofern es aus einem Verbundwerkstoff hergestellt ist. Ebenso kann das Wärmeleitmaterial vollständig aus Graphit bestehen.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Bauteile beziehen.

Es zeigen, jeweils schematisch
- Fig. 1: einen Querschnitt durch einen Wärmeübertrager,
- Fig. 2: einen Querschnitt des Wärmeübertragers im Bereich eines thermoelektrischen Generators,
- Fig. 3: eine Draufsicht auf einen Ausschnitt eines thermoelektrischen Generators,
- Fig. 4: eine perspektivische Ansicht eines thermoelektrischen Generators mit einem Rahmen.

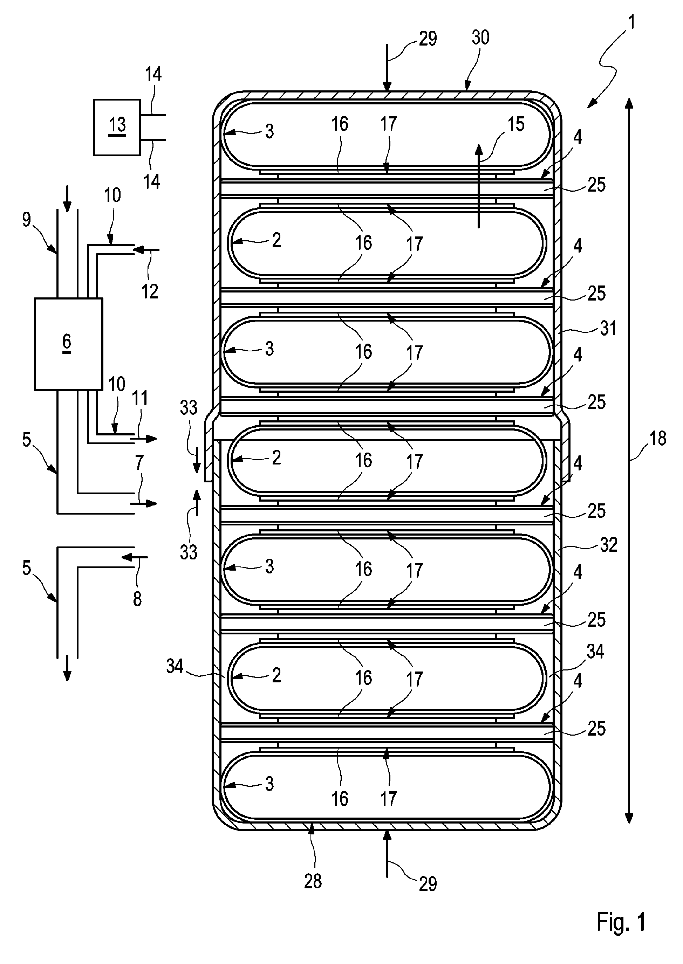

Entsprechend Fig. 1 umfasst ein im Querschnitt dargestellter Wärmeübertrager 1 zumindest ein Warmrohr 2 und zumindest ein Kaltrohr 3. Der im Beispiel gezeigte Wärmeübertrager 1 weist drei Warmrohre 2 und vier Kaltrohre 3 auf. Die Warmrohre 2 dienen im Betrieb des Wärmeübertragers 1 zum Führen eines Wärme enthaltenden oder Wärme abgebenden Fluids, während die Kaltrohre 3 im Betrieb des Wärmeübertragers 1 zum Führen eines Wärme aufnehmenden Fluids dienen.

Ferner enthält der hier gezeigte Wärmeübertrager 1 zumindest einen thermoelektrischen Generator 4, der im Folgenden auch als TEG 4 bezeichnet wird. Im Beispiel sind sechs derartige TEGs 4 vorgesehen. Der jeweilige TEG 4 dient zum Erzeugen elektrischer Energie bzw. eines elektrischen Stroms aus einer Temperaturdifferenz bzw. aus einem Wärmestrom. Hierzu ist der jeweilige TEG4 jeweils zwischen einem Warmrohr 2 und einem Kaltrohr 3 angeordnet.

Der Wärmeübertrager 1 kann beispielsweise in eine in Fig. 1 auf der linken Seite angedeutete Abgasanlage 5 einer Brennkraftmaschine 6 eingebunden sein, die insbesondere in einem Fahrzeug angeordnet sein kann. Beispielsweise kann die Abgasanlage 5 das heiße Abgas der Brennkraftmaschine 6 entsprechend einem Zulaufpfeil 7 zum Wärmeübertrager 1 führen, so dass es dort durch die Warmrohre 2 strömt. Entsprechend einem Rücklaufpfeil 8 kommt dann das gegebenenfalls gekühlte Abgas von den Warmrohren 2 des Wärmeübertragers 1 zurück und setzt seinen Weg innerhalb der Abgasanlage 5 fort. Die Brennkraftmaschine 6 weist außerdem eine Frischluftanlage 9 auf und kann mit einem Kühlkreis 10 ausgestattet sein. Beispielsweise kann der Wärmeübertrager 1 auch in diesen Kühlkreis 10 eingebunden sein. Gemäß einem Vorlaufpfeil 11 kann ein flüssiges Kühlmittel zu den Kaltrohren 3 des Wärmeübertragers 1 geführt werden. Gemäß einem Rücklaufpfeil 12 kann das gegebenenfalls erwärmte Kühlmittel von den Kaltrohren 3 des Wärmeübertragers 1 in den Kühlkreis 10 zurückgeführt werden. Hierdurch ist es beispielsweise möglich, während eines Kaltstarts der Brennkraftmaschine 6 und/oder bei niedrigen Umgebungstemperaturen Wärme in den Kühlkreis 10 einzubringen, um die Brennkraftmaschine 6 auf Betriebstemperatur zu bringen bzw. zu halten. Zusätzlich oder alternativ kann der Wärmeübertrager 1 mit seinen Kaltrohren 3 auch in einen beliebigen anderen Kühlkreis oder in einen Heizkreis, z. B. in einen Heizkreis zum Beheizen eines Fahrgastraums des Fahrzeugs, eingebunden sein.

Die TEGs 4 können mit einem elektrischen Verbraucher 13 der Brennkraftmaschine 6 bzw. des damit ausgestatteten Fahrzeugs elektrisch verbunden sein. Entsprechende elektrische Verbindungsleitungen sind dabei mit 14 bezeichnet. Der elektrische Verbraucher 13 kann einen Spannungswandler sowie ein Steuergerät umfassen, beispielsweise um die mit Hilfe der TEGs 4 gewonnene elektrische Energie in eine Fahrzeugbatterie einzuspeisen.

Im Betrieb des Wärmeübertragers 1 stellt sich zwischen den Warmrohren 2 und den Kaltrohren 3 eine Temperaturdifferenz ein, die entsprechend einem Pfeil 15 zu einem Wärmestrom von einem Warmrohr 2 zu einem Kaltrohr 3 führt, wobei der jeweilige Wärmestrom 15 durch den dazwischen angeordneten TEG 4 führt. Dieser Wärmestrom 15 bzw. die zugrunde liegende Temperaturdifferenz zwischen Warmleitung 2 und Kaltleitung 3 führt im jeweiligen TEG 4 zu einer elektrischen Spannung, die in Form von elektrischem Strom abgegriffen werden kann. Zur Verbesserung des Wärmestroms 15 steht der jeweilige TEG 4 über ein Wärmeleitmaterial 16 mit dem jeweiligen Rohr 2, 3 in Kontakt. Das jeweilige Wärmeleitmaterial 16 ist beim hier vorgestellten Wärmeübertrager 1 als Formkörper 17 ausgestaltet.

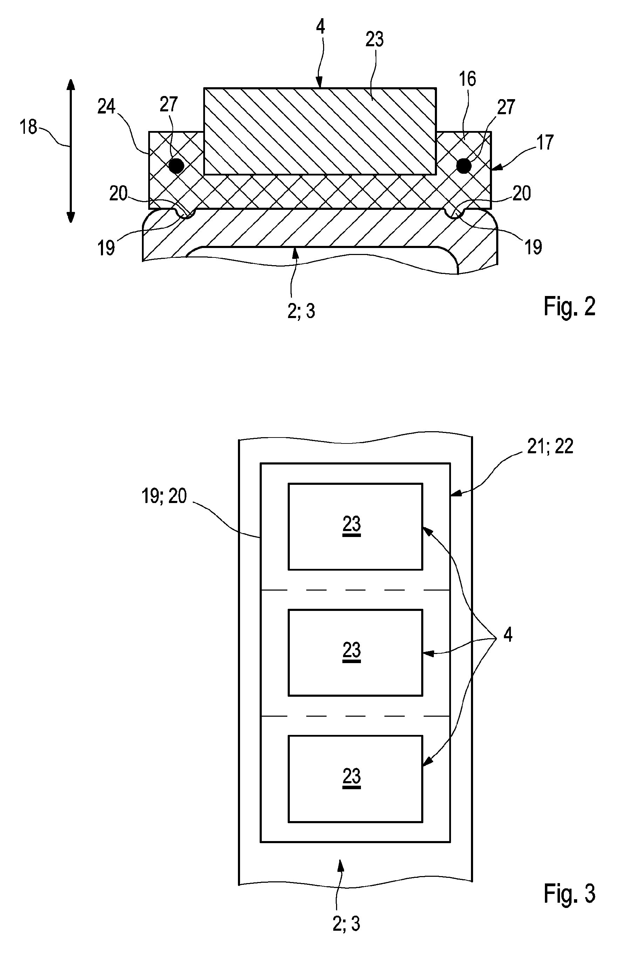

Der jeweilige Formkörper 17 kann gemäß den Fig. 2 und 3 so ausgestaltet sein, dass er den jeweiligen TEG 4 am jeweiligen Rohr 2 bzw. 3 in Position hält. Diese Positionierung erfolgt dabei quer zu einer in den Fig. 1 und 2 durch einen Doppelpfeil angedeuteten Stapelrichtung 18, in welcher die einzelnen Rohre 2, 3 und die TEGs 4 sowie die Formkörper 17 innerhalb des Wärmeübertragers 4 aufeinander gestapelt bzw. aufeinander angeordnet sind.

Zur Realisierung dieser Positionierfunktion kann gemäß den Fig. 2 und 3 am jeweiligen Formkörper 17 zumindest eine Erhebung 19 ausgebildet sein, während komplementär dazu am jeweiligen TEG 4 oder - wie im gezeigten Beispiel - am jeweiligen Rohr 2 bzw. 3 eine dazu passende Vertiefung 20 ausgebildet ist. Die Erhebung 19 greift formschlüssig in die zugehörige Vertiefung 20 ein, und zwar in der Stapelrichtung 18, wodurch sich quer zur Stapel richtung 18 die gewünschte formschlüssige Positionierung realisieren lässt. Die jeweilige Erhebung 19 kann beispielsweise linienförmig realisiert sein, beispielsweise durch einen Sicke. Ebenso ist es möglich, die jeweilige Erhebung 19 punktförmig zu gestalten, zum Beispiel als Warze. Es ist klar, dass grundsätzlich eine beliebige Kombination an Sicken und Warzen vorgesehen sein kann, um eine Erhebungsanordnung 21 zu gestalten. Entsprechendes gilt dann für die komplementär geformten Vertiefungen 20, die dementsprechend als Gegensicke oder Gegenwarze geformt sein können und in beliebiger Kombination eine Vertiefungsanordnung 22 bilden können.

Obwohl bei der in Fig. 2 gezeigten Ausführungsform die Erhebungen 19 am Formkörper 17 ausgebildet sind und am jeweiligen Rohr 2 bzw. 3 die dazu passenden Vertiefungen 20 vorgesehen sind, kann bei einer anderen Ausführungsform vorgesehen sein, am jeweiligen Formkörper 17 die Vertiefungen 20 auszubilden, während die dazu passenden Erhebungen 19 dann am jeweiligen Rohr 2 bzw. 3 oder am jeweiligen TEG 4 ausgeformt sind. Ebenso sind Kombinationen von Erhebungen 19 und Vertiefungen 20 am Formkörper 17 in Verbindung mit entsprechenden Vertiefungen 20 bzw. Erhebungen 19 am jeweiligen Rohr 2 bzw. 3 bzw. am jeweiligen TEG 4 denkbar.

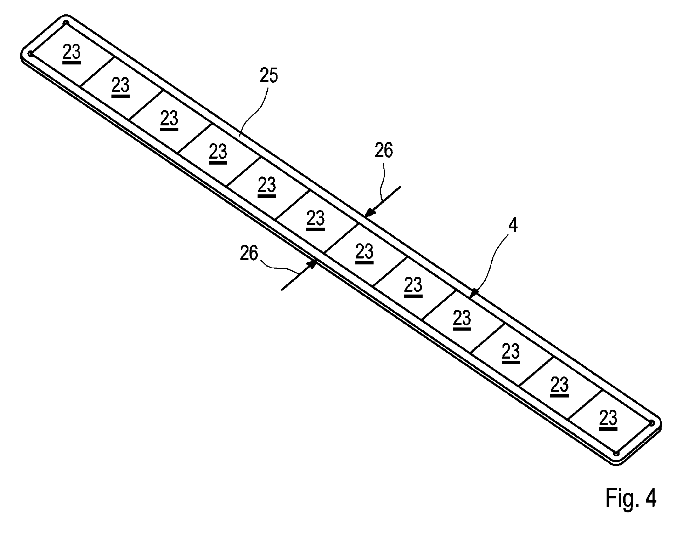

Sofern wie in Fig. 3 dargestellt eine Erhebungsanordnung 21, die aus mehreren Erhebungen 19 besteht, und/oder eine Vertiefungsanordnung 22, die aus mehreren Vertiefungen 20 besteht, vorgesehen ist bzw. sind, kann die jeweilige Erhebungsanordnung 21 bzw. Vertiefungsanordnung 22 so konfiguriert sein, dass sie den jeweiligen thermoelektrischen Generator 4 seitlich, also quer zur Stapelrichtung 18 umfasst. Zusätzlich oder alternativ kann vorgesehen sein, dass die jeweilige Erhebungsanordnung 21 bzw. die jeweilige Vertiefungsanordnung 22 ein thermoelektrisches Generatorelement 23, das im Folgenden auch als TEG-Element 23 bezeichnet wird, seitlich umfasst. Ein TEG 4 kann aus mehreren solchen TEG-Elementen 23 gebildet sein. Beispielsweise zeigt Fig. 4 eine Ausführungsform, bei welcher ein einzelner TEG 4 aus insgesamt zwölf TEG-Elementen 23 aufgebaut ist. Die einzelnen TEG-Elemente 23 liegen hierbei quer zur Stapelrichtung 18 in einer Linie nebeneinander. Ihre Anzahl bestimmt sich aus der Länge der im Wärmeübertrager 1 verwendeten Rohre 2, 3.

Zur Veranschaulichung der Gestaltung der Erhebungsanordnung 21 bzw. der Vertiefungsanordnung 22 ist in Fig. 3 der Formkörper 17 nicht dargestellt. Gemäß Fig. 2 weist der Formkörper 17 einen Rand 24 auf, der vom übrigen Formkörper 17 in der Stapelrichtung 18 absteht. Der Rand 24 ist dabei so positioniert, dass er den jeweiligen TEG 4 bzw. zumindest ein TEG-Element 23 seitlich zumindest teilweise einfasst. Im Beispiel der Fig. 2 fasst der Rand 24 den TEG 4 bzw. das TEG-Element 23 an zwei sich gegenüberliegenden Längsseiten ein. Besagter Rand 24 kann zusätzlich oder alternativ zu den Erhebungen 19 bzw. Vertiefungen 20 vorgesehen sein. Im Beispiel führt der Rand 24 zu einer seitlichen Positionierung des TEG 4 bzw. des jeweiligen TEG-Elements 23 relativ zum Formkörper 17, während die miteinander zusammenwirkenden Erhebungen 19 und Vertiefungen 20 zur Positionierung des jeweiligen Rohrs 2 bzw. 3 relativ zum Formkörper 17 führen.

Gemäß Fig. 4 kann zusätzlich zu den Rohren 2, 3 und den TEGs 4 zumindest ein Rahmen 25 im Wärmeübertrager 1 vorgesehen sein. Zweckmäßig ist dabei je TEG 4 ein solcher Rahmen 25 vorhanden. Dementsprechend zeigt Fig. 1 insgesamt sechs derartige Rahmen 25. Der jeweilige Rahmen 25 bildet eine seitliche, also quer zur Stapelrichtung 18 orientierte Einfassung für das jeweilige TEG 4. Erkennbar sind gemäß Fig. 4 alle TEG-Elemente 23 des jeweiligen TEGs 4 innerhalb des jeweiligen Rahmens 25 in einer Reihe nebeneinander angeordnet. Hierdurch ergibt sich für den TEG 4 bzw. für dessen TEG-Elemente 23 ein in Fig. 4 durch Pfeile 26 angedeutete Positionierungswirkung, die quer zur Stapelrichtung 18 und quer zur Längsrichtung der Rohre 2, 3 und somit quer zur Strömungsrichtung des jeweiligen Fluids im jeweiligen Rohr 2, 3 orientiert ist.

Der jeweilige Formkörper 17 kann nun entsprechend einer zweckmäßigen Ausgestaltungsform so konfiguriert sein, dass er im zusammengebauten Zustand am jeweiligen Rahmen 25 abgestützt ist. Somit kann die Positionierung des jeweiligen TEGs 4 quer zur Stapelrichtung 18 mit Hilfe des jeweiligen Formkörpers 17 indirekt über die Positionierung des Rahmens 25 realisiert werden. Beispielsweise können am Formkörper 17 Erhebungen 19 bzw. Vertiefungen 20 vorgesehen sein, die in dazu komplementäre Vertiefungen 20 bzw. Erhebungen 19, die dann am Rahmen 25 ausgeformt sind, eingreifen.

Entsprechend Fig. 2 können in den Formkörper 17 elektrische Leitungen 27 integriert sein, die auf geeignete Weise eine elektrische Kontaktierung des jeweiligen TEGs 4 bzw. des jeweiligen TEG-Elements 23 ermöglichen. Beispielsweise müssen die einzelnen TEG-Elemente 23 des jeweiligen TEGs 4 elektrisch in Reihe oder elektrisch parallel geschaltet werden, um den jeweiligen TEG 4 zu realisieren. Die jeweilige Verschaltung der TEG-Elemente 23 kann dabei über die Leitungen 27 realisiert werden. Hierdurch erhält der Formkörper 17 eine wichtige Zusatzfunktion, nämlich die elektrische Verschaltung der TEG-Elemente 23. Darüber hinaus kann mit Hilfe der in den Formkörper 17 integrierten Leitungen 27 auch die elektrische Verschaltung der einzelnen TEGs 4 innerhalb des Wärmeübertragers 1 erheblich vereinfacht werden.

Die Formkörper 17 sind zweckmäßig formstabil ausgestaltet, wodurch es möglich ist, im Rahmen der Montage des Wärmeübertragers 1 mehrere Rohre 2, 3 und mehrere TEGs 4 mit Hilfe der Formkörper 17 sicher aufeinander zu stapeln. Des Weiteren können die Formkörper 17 elastisch ausgestaltet sein, wodurch sie bei einer Verpressung parallel zur Stapelrichtung 18 soweit elastisch nachgeben können, dass sie sich an die Außenkonturen der Rohre 2, 3 und TEGs 4 anschmiegen können, wodurch eine hochwertige, flächige Kontaktierung realisierbar ist. Der jeweilige Formkörper 17 kann mit dem jeweiligen Rohr 2, 3 verklebt sein. Zusätzlich oder alternativ kann der jeweilige Formkörper 17 mit dem jeweiligen TEG 4 bzw. mit dessen TEG-Elementen 23 verklebt sein. Eine derartige Verklebung kann die Handhabung während der Montage vereinfachen.

Der jeweilige Formkörper 17 ist zweckmäßig an seiner dem jeweiligen TEG 4 zugewandten Seite komplementär zu der dem Formkörper 17 zugewandten Seite des jeweiligen TEGs 4 geformt. Zusätzlich oder alternativ kann der jeweilige Formkörper 17 an seiner dem jeweiligen Rohr 2, 3 zugewandten Seite komplementär zu der dem jeweiligen Formkörper 17 zugewandten Seite des jeweiligen Rohrs 2, 3 geformt sein. Die komplementäre Formgebung vereinfacht eine großflächige Kontaktierung, was die Wärmeübertragung verbessert.

Das zur Herstellung des Formkörpers 17 verwendete Wärmeleitmaterial 16 kann entsprechend einer bevorzugten Ausführungsform elektrisch isolierend sein. Das Wärmeleitmaterial 16 kann faserverstärkt sein. Beispielsweise kann es Glasfasern oder Graphitfasern enthalten. Des Weiteren kann das Wärmeleitmaterial 16 ein Verbundmaterial sein, das mehrere Werkstoffe umfasst. Beispielsweise kann als Basismaterial für diesen Verbund Graphit verwendet werden. Ebenso ist es möglich, das Wärmeleitmaterial 16 nur bzw. vollständig aus Graphit herzustellen.

Gemäß Fig. 1 bilden die Rohre 2, 3, die Formkörper 17 und die TEGs 4 in der Stapelrichtung 18 einen Stapel 28. Bevorzugt ist nun eine Ausführungsform, bei welcher die einzelnen Komponenten des Stapels 28, also die Rohre 2, 3, die TEGs 4 und die Formkörper 17 im Stapel 28 mit einer in Fig. 1 durch Pfeile angedeuteten Vorspannkraft 29 gegeneinander vorgespannt sind. Diese Vorspannkraft 29 wirkt dabei parallel zur Stapelrichtung 18.

Der Wärmeübertrager 1 weist gemäß Fig. 1 ein Gehäuse 30 auf, das zwei Gehäuseteile 31 und 32 aufweist. In Fig. 1 sind ein topfförmiges oder im Querschnitt U-förmiges oberes Gehäuseteil 31 und ein topfförmiges oder im Querschnitt U-förmiges unteres Gehäuseteil 32 erkennbar. Die beiden Gehäuseteile 31, 32 sind entsprechend Pfeilen 33 ineinander gesteckt. Diese Steckrichtung 33 verläuft dabei parallel zur Stapelrichtung 18. Der Stapel 28 ist im Gehäuse 30, also in den beiden Gehäuseteilen 31, 32 angeordnet. Die Vorspannkraft 29 wird über die Gehäuseteile 31, 32 auf den Stapel 28 aufgebracht.

Bei der in Fig. 1 gezeigten Ausführungsform sind die Kaltrohre 3 so dimensioniert, dass sie das Gehäuse 30 quer zur Durchströmungsrichtung und quer zur Stapelrichtung 18 seitlich berühren. Auch die Rahmen 25 sind hier so dimensioniert, dass sie das Gehäuse 30 quer zur Durchströmungsrichtung und quer zur Stapelrichtung 18 seitlich berühren. Im Unterschied dazu sind die Warmrohre 2 hier so dimensioniert, dass sie quer zur Durchströmungsrichtung und quer zur Stapelrichtung 18 vom Gehäuse 30 beabstandet sind. Erkennbar ist hierbei eine Lücke 34 zwischen dem jeweiligen Warmrohr 2 und dem Gehäuse 30. Mit Hilfe dieser Lücke 34 können thermisch bedingte Spannungen im Gehäuse 30 vermieden werden, die aufgrund einer thermischen Ausdehnung der Warmrohre 2 im Betrieb des Wärmeübertragers 1 auftreten können.

Der hier vorgestellte Wärmeübertrager 1 kann entsprechend einem vorteilhaften Herstellungsverfahren wie folgt zusammengebaut werden:
Zunächst wird der Stapel 28 aufgebaut, indem die jeweiligen Rohre 2, 3 und der jeweilige TEG 4 mit dazwischen angeordneten Formkörpern 17 aufeinander gestapelt werden. Dieser Stapel 28 wird im Gehäuse 30 untergebracht. Dabei ist es grundsätzlich möglich, den Stapel 28 bereits im Gehäuse 30 bzw. in wenigstens einem der Gehäuseteile 31, 32 aufzubauen.

Nach dem Unterbringen des Stapels 28 im Gehäuse 30 werden die Gehäuseteile 31, 32 in der Stapelrichtung 18 vorgespannt, um die Vorspannkraft 29 im Stapel 28 zu erzeugen. In diesem vorgespannten Zustand kann die Relativlage zwischen den Gehäuseteilen 31, 32 fixiert werden. Diese Lagefixierung kann beispielsweise mittels wenigstens eines die Gehäuseteile 31, 32 umschließenden Spannbands realisiert werden. Zusätzlich oder alternativ ist es ebenso möglich, diese Lagefixierung mit Hilfe einer Befestigung zu realisieren, welche die beiden Gehäuseteile 31, 32 in ihrer Relativlage aneinander fixiert. Beispielsweise können die Gehäuseteile 31, 32 miteinander verschweißt werden.

## Patentansprüche

1. Wärmeübertrager, insbesondere für eine Abgasanlage (5) einer Brennkraftmaschine (6), vorzugsweise eines Kraftfahrzeugs,
- mit wenigstens einem Warmrohr (2) zum Führen eines Wärme abgebenden Fluids,
- mit wenigstens einem Kaltrohr (3) zum Führen eines Wärme aufnehmenden Fluids,
- mit wenigstens einem thermoelektrischen Generator (4) zum Erzeugen von elektrischer Energie aus einer Temperaturdifferenz, wobei je ein thermoelektrischer Generator (4) zwischen einem Warmrohr (2) und einem Kaltrohr (3) angeordnet ist,
- wobei der jeweilige thermoelektrische Generator (4) über ein Wärmeleitmaterial (16) mit dem jeweiligen Rohr (2, 3) in Kontakt steht,
- wobei das jeweilige Wärmeleitmaterial (16) als Formkörper (17) ausgestaltet ist,
**dadurch gekennzeichnet,**
**dass** der jeweilige Formkörper (17) einen Rand (24) aufweist, der den jeweiligen thermoelektrischen Generator (4) oder zumindest ein thermoelektrisches Generatorelement (23) eines aus mehreren thermoelektrischen Generatorelementen (23) gebildeten thermoelektrischen Generators (4) zumindest teilweise seitlich einfasst.

2. Wärmeübertrager nach Anspruch 1,
**dadurch gekennzeichnet,**
**dass** der jeweilige thermoelektrische Generator (4) mit Hilfe des jeweiligen Formkörpers (17) am jeweiligen Rohr (2, 3) in Position gehalten ist.

3. Wärmeübertrager nach Anspruch 1 oder 2,
**dadurch gekennzeichnet,**
**dass** am jeweiligen Formkörper (17) zumindest eine Erhebung (19) oder Vertiefung (20), zum Beispiel in Form einer Sicke oder Warze, ausgebildet ist, die mit einer dazu komplementären Vertiefung (20) oder Erhebung (19), zum Beispiel in Form einer Gegensicke oder Gegenwarze, zusammenwirkt, die am jeweiligen thermoelektrischen Generator (4) oder am jeweiligen Rohr (2, 3) ausgebildet ist.

4. Wärmeübertrager nach Anspruch 3,
**dadurch gekennzeichnet,**
**dass** die jeweilige Erhebung (19) oder Vertiefung (20) oder eine aus mehreren Erhebungen (19) oder Vertiefungen (20) bestehende Erhebungsanordnung (21) oder Vertiefungsanordnung (22) den jeweiligen thermoelektrischen Generator (4) oder zumindest ein thermoelektrisches Generatorelement (23) eines aus mehreren thermoelektrischen Generatorelementen (23) gebildeten thermoelektrischen Generators (4) seitlich umfasst.

5. Wärmeübertrager nach einem der Ansprüche 1 bis 4,
**dadurch gekennzeichnet,**
**dass** zumindest ein Rahmen (25) vorgesehen ist, der den jeweiligen thermoelektrischen Generator (4) seitlich einfasst, wobei insbesondere vorgesehen sein kann, dass der jeweilige Formkörper (17) am jeweiligen Rahmen (25) abgestützt ist.

6. Wärmeübertrager nach einem der Ansprüche 1 bis 5,
**dadurch gekennzeichnet,**
**dass** in den jeweiligen Formkörper (17) elektrische Leitungen (27) zum elektrischen Kontaktieren des jeweiligen thermoelektrischen Generators (4) und/oder von thermoelektrischen Generatorelementen (23) eines aus mehreren thermoelektrischen Generatorelementen (23) gebildeten thermoelektrischen Generators (4) integriert sind.

7. Wärmeübertrager nach einem der Ansprüche 1 bis 6,
**dadurch gekennzeichnet,**
- **dass** der jeweilige Formkörper (17) formstabil ausgestaltet ist, und/oder
- **dass** der jeweilige Formkörper (17) elastisch ausgestaltet ist, und/oder
- **dass** der jeweilige Formkörper (17) mit dem jeweiligen Rohr (2, 3) und/oder mit dem jeweiligen thermoelektrischen Generator (4) verklebt ist, und/oder
- **dass** das Wärmeleitmaterial (16) elektrisch isolierend ist, und/oder
- **dass** das Wärmeleitmaterial (16) faserverstärkt ist, und/oder
- **dass** das Wärmeleitmaterial (16) Graphit als Basismaterial aufweist oder vollständig aus Graphit besteht.

8. Wärmeübertrager nach einem der Ansprüche 1 bis 7,
**dadurch gekennzeichnet,**
- **dass** die jeweiligen Rohre (2, 3), die jeweiligen Formkörper (17) und der jeweilige thermoelektrische Generator (4) in einer Stapelrichtung (18) aufeinander gestapelt sind und einen Stapel (28) bilden, in dem sie in der Stapelrichtung (18) mit einer Vorspannkraft (29) gegeneinander verspannt sind,
- wobei insbesondere vorgesehen sein kann, dass ein Gehäuse (30) vorgesehen ist, in dem der jeweilige Stapel (28) angeordnet ist und das zwei ineinander gesteckte Gehäuseteile (31, 32) aufweist, über welche die Vorspannkraft (29) auf den jeweiligen Stapel (28) aufgebracht ist.

9. Wärmeübertrager nach einem der Ansprüche 1 bis 8,
**dadurch gekennzeichnet,**
- **dass** das jeweilige Kaltrohr (3) quer zur Durchströmungsrichtung seitlich ein Gehäuse (30) des Wärmeübertragers (1) berührt, und/oder
- **dass** der jeweilige Rahmen (25) quer zur Durchströmungsrichtung seitlich ein Gehäuse (30) des Wärmeübertragers (1) berührt, und/oder
- **dass** das jeweilige Warmrohr (2) quer zur Durchströmungsrichtung seitlich von einem Gehäuse (30) des Wärmeübertragers (1) beabstandet ist.

10. Verfahren zum Zusammenbauen eines Wärmeübertragers (1) nach einem der Ansprüche 1 bis 9,
- bei dem ein Stapel (28) aufgebaut wird, indem die jeweiligen Rohre (2, 3) und der jeweilige thermoelektrische Generator (4) mit dazwischen angeordneten Formkörpern (17) aufeinander gestapelt werden,
- bei dem der Stapel (28) in einem Gehäuse (30) untergebracht wird,
- bei dem optional der Stapel (28) im Gehäuse (30) oder in einem Gehäuseteil (31, 32) aufgebaut wird,
- bei dem optional ineinander steckbare Gehäuseteile (31, 32) in der Stapelrichtung (18) des Stapels (28) vorgespannt werden.

## Claims

1. Heat exchanger, in particular for an exhaust gas system (5) of an internal combustion engine (6), preferably of a motor vehicle, comprising:
- at least one warm tube (2) for conducting a fluid which emits heat,
- at least one cold tube (3) for conducting a fluid which absorbs heat,
- at least one thermoelectric generator (4) for generating electrical energy from a temperature difference, a thermoelectric generator (4) being arranged in each case between a warm tube (2) and a cold tube (3),
- the respective thermoelectric generator (4) being in contact with the respective tube (2, 3) via a heat-conducting material (16),
- the respective heat-conducting material (16) being configured as a moulded body (17),
**characterised in that**
the respective moulded body (17) has an edge (24) which laterally encloses, at least in part, the respective thermoelectric generator (4) or at least one thermoelectric generator element (23) of a thermoelectric generator (4) formed from a plurality of thermoelectric generator elements (23).

2. Heat exchanger according to claim 1, **characterised in that** the respective thermoelectric generator (4) is held in position on the respective tube (2, 3) with the aid of the respective moulded body (17).

3. Heat exchanger according to either claim 1 or claim 2, **characterised in that** on the respective moulded body (17) at least one elevation (19) or depression (20), for example in the form of a bead or projection, is formed, which interacts with a depression (20) or elevation (19) complementary thereto, for example in the form of a mating bead or mating projection, which is formed on the respective thermoelectric generator (4) or on the respective tube (2, 3).

4. Heat exchanger according to claim 3, **characterised in that** the respective elevation (19) or depression (20), or an elevation arrangement (21) or a depression arrangement (22) consisting of a plurality of elevations (19) or depressions (20), laterally encloses the respective thermoelectric generator (4) or at least one thermoelectric generator element (23) of a thermoelectric generator (4) formed from a plurality of thermoelectric generator elements (23).

5. Heat exchanger according to any of claims 1 to 4, **characterised in that** at least one frame (25) is provided which laterally encloses the respective thermoelectric generator (4), it being possible to provide in particular that the respective moulded body (17) is supported on the respective frame (25).

6. Heat exchanger according to any of claims 1 to 5, **characterised in that** integrated in the respective moulded body (17) are electrical lines (27) for the electrical contacting of the respective thermoelectric generator (4) and/or of thermoelectric generator elements (23) of a thermoelectric generator (4) formed from a plurality of thermoelectric generator elements (23).

7. Heat exchanger according to any of claims 1 to 6, **characterised in that**
- the respective moulded body (17) is configured to be dimensionally stable, and/or
- the respective moulded body (17) is configured to be resilient, and/or
- the respective moulded body (17) is glued to the respective tube (2, 3) and/or to the respective thermoelectric generator (4), and/or
- the heat-conducting material (16) is electrically insulating, and/or
- the heat-conducting material (16) is fibre-reinforced, and/or
- the heat-conducting material (16) comprises graphite as base material or consists entirely of graphite.

8. Heat exchanger according to any of claims 1 to 7, **characterised in that**
- the respective tubes (2, 3), the respective moulded bodies (17) and the respective thermoelectric generator (4) are stacked on top of one another in a stacking direction (18) and form a stack (28), in which they are clamped against one another with a preload force (29) in the stacking direction (18),
- it being possible to provide in particular that a housing (30) is provided, in which the respective stack (28) is arranged and which comprises two housing parts (31, 32) inserted into each other, via which the preload force (29) is exerted on the respective stack (28).

9. Heat exchanger according to any of claims 1 to 8, **characterised in that**
- the respective cold tube (3), transversely to the flow direction, laterally touches a housing (30) of the heat exchanger (1), and/or
- the respective frame (25), transversely to the flow direction, laterally touches a housing (30) of the heat exchanger (1), and or
- the respective warm tube (2), transversely to the flow direction, is laterally spaced from a housing (30) of the heat exchanger (1).

10. Method for assembling a heat exchanger (1) according to any of claims 1 to 9, in which method:
- a stack (28) is constructed, in which the respective tubes (2, 3) and the respective thermoelectric generator (4) having the moulded bodies (17) arranged in between are stacked on top of one another,
- the stack (28) is accommodated in a housing (30),
- the stack (28) is optionally constructed in the housing (30) or in a housing part (31, 32),
- the housing parts (31, 32), which are optionally insertable into each other, are preloaded in the stacking direction (18) of the stack (28).

## Revendications

1. Échangeur de chaleur, en particulier pour une installation de gaz d'échappement (5) d'un moteur à combustion interne (6), de préférence d'un véhicule à moteur,
- avec au moins un tube de chaleur (2) destiné à conduire un fluide émettant de la chaleur,
- avec au moins un tube de réfrigération (3) destiné à conduire un fluide absorbant de la chaleur,
- avec au moins un générateur thermoélectrique (4) destiné à la production d'une énergie électrique à partir d'un écart de température, dans lequel un générateur thermoélectrique (4) est disposé respectivement entre un tube de chaleur (2) et un tube de réfrigération (3),
- dans lequel le générateur thermoélectrique (4) respectif est en contact avec le tube respectif (2, 3) par l'intermédiaire d'un matériau conducteur de chaleur (16),
- dans lequel le matériau conducteur de chaleur (16) respectif est conçu comme un corps moulé (17),
**caractérisé en ce que**
le corps moulé (17) respectif présente une bordure (24) qui entoure latéralement, au moins en partie, le générateur thermoélectrique respectif (4) ou au moins un élément de générateur thermoélectrique (23) d'un générateur thermoélectrique (4) formé de plusieurs éléments de générateur thermoélectrique (23).

2. Échangeur de chaleur selon la revendication 1,
**caractérisé en ce que**
le générateur thermoélectrique (4) respectif est maintenu en position au niveau du tube respectif (2, 3) à l'aide du corps moulé (17) respectif.

3. Échangeur de chaleur selon la revendication 1 ou 2,
**caractérisé en ce qu'**
au niveau du corps moulé (17) respectif est conçu au moins une élévation (19) ou un creux (20), par exemple sous la forme d'une moulure ou d'un bossage, qui interagit avec un creux (20) ou une élévation (19) qui lui est complémentaire, par exemple sous la forme d'une contre-moulure ou d'un contre-bossage, qui est conçu au niveau du générateur thermoélectrique (4) respectif ou au niveau du tube (2, 3) respectif.

4. Échangeur de chaleur selon la revendication 3,
**caractérisé en ce que**
l'élévation (19) respective ou le creux (20) respectif ou une disposition en élévation (21) ou une disposition en creux (22) composée respectivement de plusieurs élévations (19) ou de plusieurs creux (20) entoure latéralement le générateur thermoélectrique (4) respectif, ou au moins un élément de générateur thermoélectrique (23) d'un générateur thermoélectrique (4) formé de plusieurs éléments de générateur thermoélectrique (23).

5. Échangeur de chaleur selon l'une des revendications 1 à 4,
**caractérisé en ce qu'**
au moins un châssis (25) est prévu, qui entoure latéralement le générateur thermoélectrique (4) respectif, dans lequel il peut être prévu en particulier que le corps moulé (17) respectif vienne s'appuyer au niveau du châssis (25) respectif.

6. Échangeur de chaleur selon l'une des revendications 1 à 5,
**caractérisé en ce que**
des conducteurs électriques (27) sont intégrés dans les corps moulés (17) respectifs en vue d'établir un contact électrique du générateur thermoélectrique (4) respectif et/ou d'éléments de générateur thermoélectrique (23) d'un générateur thermoélectrique (4) formé de plusieurs éléments de générateur thermoélectrique (23).

7. Échangeur de chaleur selon l'une des revendications 1 à 6,
**caractérisé en ce que**
- la structure du corps moulé (17) respectif est indéformable, et/ou
- la structure du corps moulé (17) respectif est élastique, et/ou
- le corps moulé (17) respectif est encollé avec le tube (2, 3) respectif et/ou avec le générateur thermoélectrique (4) respectif, et/ou
- le matériau conducteur de chaleur (16) est un isolant électrique, et/ou
- le matériau conducteur de chaleur (16) est renforcé par des fibres, et/ou
- le matériau conducteur de chaleur (16) présente du graphite comme matériau de base ou est composé intégralement de graphite.

8. Échangeur de chaleur selon l'une des revendications 1 à 7,
**caractérisé en ce que**
- les tubes (2, 3) respectifs, les corps moulés (17) respectifs et le générateur thermoélectrique (4) respectif sont empilés les uns sur les autres dans un sens d'empilage (18) et forment une pile (28) dans laquelle ils sont serrés les uns contre les autres dans le sens d'empilage (18) au moyen d'une force de précontrainte (29),
- dans lequel il peut être prévu en particulier qu'un carter (30) soit prévu dans lequel la pile (28) respective est disposée et qui présente deux parties de carter (31, 32) insérées l'une dans l'autre, par l'intermédiaire desquelles la force de précontrainte (29) est appliquée sur la pile (28) respective.

9. Échangeur de chaleur selon l'une des revendications 1 à 8,
**caractérisé en ce que**
- le tube de réfrigération (3) respectif entre latéralement en contact, transversalement à la direction d'écoulement, avec un carter (30) de l'échangeur de chaleur (1), et/ou
- le châssis (25) respectif entre latéralement en contact, transversalement à la direction d'écoulement, avec un carter (30) de l'échangeur de chaleur (1), et/ou
- le tube de chaleur (2) respectif est espacé latéralement, à la direction d'écoulement, d'un carter (30) de l'échangeur de chaleur (1).

10. Procédé destiné à l'assemblage d'un échangeur de chaleur (1) selon l'une des revendications 1 à 9,
- pour lequel une pile (28) est mise en place en empilant les uns sur les autres les tubes (2, 3) respectifs et le générateur thermoélectrique (4) respectif avec des corps moulés (17) qui sont disposés entre eux,
- pour lequel la pile (28) est installée dans un carter (30),
- pour lequel la pile (28) est mise en place de manière facultative dans le carter (30) ou dans une partie de carter (31, 32),
- pour lequel des parties de carter (31, 32), insérables de manière facultative l'une dans l'autre, sont serrées dans le sens d'empilage (18) de la pile (28).
